# EUROPÄISCHE PATENTSCHRIFT

(11) **EP 1 257 057 B1**
(45) Veröffentlichungstag und Bekanntmachung des Hinweises auf die Patenterteilung: **11.06.2008**
(21) Anmeldenummer: 02007968.7
(22) Anmeldetag: 10.04.2002
(51) Int. Cl.: H03K 17/96

(54) **Sensorelement für einen kapazitiven Berührungsschalter**
Sensor element for a capacitive touch switch
Elément capteur pour un commutateur capacitif à effleurement

(30) Priorität: 09.05.2001 DE 10123633
(43) Veröffentlichungstag der Anmeldung: 13.11.2002
(73) Patentinhaber: E.G.O. ELEKTRO-GERÄTEBAU GmbH, D-75038 Oberderdingen (DE)
(72) Erfinder: Kleinhans, Andreas, 75015 Bretten (DE); Schilling, Wilfried, 76703 Kraichtal (DE)
(74) Vertreter: Patentanwälte Ruff, Wilhelm, Beier, Dauster & Partner

(56) Entgegenhaltungen:
- EP-A- 1 030 536
- DE-A- 19 714 195
- DE-C- 19 817 195
- US-A- 5 917 165

## Beschreibung

Die Erfindung betrifft ein Sensorelement gemäß dem Oberbegriff des Anspruchs 1. Eine bevorzugte Anwendung ist ein Berührungsschalter für Hausgeräte, beispielsweise ein Kochfeld.

Sensorelemente mit einer Sensorfläche, die einen Teil eines kapazitiven Berührungsschalters bilden, wobei die Sensorfläche an der Unterseite einer Bedienoberfläche angebracht ist, sind aus dem Stand der Technik bekannt. Zur optischen Funktionsanzeige für eine solche Sensorfläche bzw. einen Berührungsschalter sind in manchen Fällen neben der Sensorfläche LED oder ähnliche Leuchtmittel unter der Bedienoberfläche angebracht. Dabei besteht oftmals das Problem, dass diese Leuchtmittel einen größeren Bereich beleuchten als eigentlich gewollt.

Die US-A-5917165 zeigt eine langgestreckte und voluminöse Schaumstoff-Sensortaste aus elektrisch leitfähigem Material. Sie weist eine durchgehende Öffnung entlang der Mittellängsachse auf. Im unter eine Bedienoberfläche montierten Zustand wird ihre Oberseite gegen die Unterseite der Bedienoberfläche angedrückt, wobei diese Oberseite die Sensorfläche darstellt. Die Unterseite der Sensortaste ist gegen eine Leiterplatte gedrückt, wobei eine LED in der durchgehenden Öffnung angebracht sein kann. Diese leuchtet nach oben und stellt eine für eine Bedienperson erkennbare Kennzeichnung dar.

Die DE-A-19714195 zeigt eine Beleuchtung hinter einer Berührfläche, wobei sie eine Anzeigeeinrichtung umfasst. Die Berührfläche weist einen auf Druck ansprechenden Piezosensor auf um eine Berührung bzw. Bedienung zu erfassen. Hierbei ist notwendigerweise die Berührfläche derart auszubilden, dass sie elastisch ist bzw. die durch den Druck hervorgerufene Bewegung an den Sensor weitergeben kann.

### Aufgabe und Lösung

Es ist Aufgabe der Erfindung, ein eingangs genanntes Sensorelement zu schaffen, bei dem eine beleuchtete Kennzeichnung einer Sensorfläche innerhalb der Sensorfläche möglich ist sowie keine ungewünschte Abstrahlung der Beleuchtung erfolgt.

Diese Aufgabe wird durch ein Sensorelement mit den Merkmalen des Anspruchs 1 gelöst. Vorteilhafte Ausgestaltungen der Erfindung sind Gegenstand der weiteren Ansprüche und werden im folgenden näher erläutert.

Durch die erfindungsgemäße Lichtdurchlässigkeit der Sensorfläche, die als Transparenz oder Transluzenz ausgebildet sein kann, kann auf einfache Art und Weise im Bereich der Sensorfläche selber eine leuchtende Markierung erzeugt werden. Diese leuchtende Markierung wird durch die unterhalb der Sensorfläche angebrachte Lichtquelle erzeugt. Die Lichtleitmittel sorgen für eine zuverlässige und im wesentlichen genaue Beleuchtung der gewünschten Stelle, nämlich der Sensorfläche bzw. innerhalb der Sensorfläche. So kann Streuung von Licht nach außerhalb des vorgesehenen Bereichs vermieden werden, indem die Lichtleitmittel dies unterbinden.

Vorteilhaft ist pro Sensorelement eine Lichtquelle bzw. ein Lichtleitmittel vorgesehen. So ist eine individuelle optische Kennzeichnung eines jeden Sensorelements möglich. Bei einer Anordnung mit mehreren Sensorelementen sollte dies für jedes einer individuellen Funktion zugehöriges Sensorelement vorgesehen sein. Allgemein verwendete Sensorelemente können mit einer gemeinsamen Beleuchtung versehen werden.

Die Lichtleitmittel können die Lichtquelle eines Berührungsschalters gegen die Umgebung abschirmen, beispielsweise gegen die gesamte Umgebung unterhalb einer Bedienoberfläche. Die Bedienoberfläche kann im Anwendungsfall eines Berührungsschalters für eine Kochstelle das Kochfeld selber sein, beispielsweise aus Glaskeramik. Vorteilhaft schirmen die Lichtleitmittel die Lichtquelle gegen andere Berührungsschalter und/oder die übrige Unterseite der Bedienoberfläche ab, die insbesondere lichtdurchlässig sein kann. Aus diesem Grunde ist eine Abschirmung bei einer lichtdurchlässigen Bedienoberfläche von großer Bedeutung.

Die Lichtleitmittel können eine Wandung aufweisen, die die wenigstens eine Lichtquelle umgibt und einen Kanal zur Sensorfläche bildet. Auf diese Weise kann vorteilhaft ein geschlossener Kanal zwischen Lichtquelle und Sensorfläche gebildet werden. Der Kanal ist dabei im wesentlichen lichtdicht geschlossen. Die Lichtleitmittel können zumindest teilweise selber als Kanalwandung ausgebildet sein bzw. lediglich aus einem Kanal bzw. seiner Wandung bestehen. Die an sich lose Sensorfläche wird von den Lichtleitmitteln gegen die Unterseite der Bedienoberfläche gedrückt. Dieses Andrücken kann elastisch erfolgen. Eine solche Sensorfläche kann beispielsweise als elektrisch leitfähige Scheibe oder Plättchen ausgebildet sein. Besonders bevorzugt bestehen die Lichtleitmittel aus Kunststoff bzw. sind flexibel ausgeführt. So lässt sich die Fertigung vereinfachen und die Anwendung ist vielseitig.

Die Lichtleitmittel können eine elektrische Kontaktierung an die Sensorfläche bilden, beispielsweise von der zugehörigen Sensorflächensteuerung. Auf diese Weise können separate Kontaktierungen wie beispielsweise Kabel oder dergleichen eingespart werden. Zu diesem Zweck sind die Lichtleitmittel elektrisch leitend auszuführen, beispielsweise durch elektrisch leitfähigen Kunststoff.

Die Lichtleitmittel können eine reflektierende Oberfläche aufweisen. Ist diese auf der der Lichtquelle zugewandten Oberfläche vorgesehen, lässt sich der Wirkungsgrad erhöhen. Dies ist besonders bei Lichtleitmitteln in Kanalform von Vorteil, wobei eine Innenverspiegelung des Kanals den Wirkungsgrad erhöht.

Bei einem vorstehend beschriebenen Sensorelement kann die Lichtquelle in Abhängigkeit vom Schaltzustand des Berührungsschalters veränderbar sein. Beispielsweise kann sie entsprechend dem Berührungsschalter aktiviert oder deaktiviert sein und somit dessen Schaltzustand optisch anzeigen.

Um die Anordnung möglichst einfach auszuführen, kann eine Lichtquelle im wesentlichen unterhalb der Sensorfläche angeordnet sein und mittels eines Kanals oder dergleichen als Lichtleitmittel an die Sensorfläche angekoppelt sein. Beispielsweise können Lichtquelle und Lichtleitmittel auf einer Platine unterhalb der Bedienoberfläche angeordnet sein.

Zur Darstellung von Symbolen oder dergleichen im beleuchteten Zustand kann die Sensorfläche zumindest teilweise lichtdurchlässig bzw. transparent oder transluzent ausgebildet sein. Gemäß einer Möglichkeit enthält sie entsprechend lichtdurchlässige Ausnehmungen in Form der Symbole, die dargestellt werden sollen. Diese werden von dem Licht durchleuchtet und stellen sich durch die Bedienoberfläche hindurch dar.

Des weiteren ist es möglich, dass die Lichtleitmittel Licht von der Lichtquelle in Form eines darzustellenden Symbols auf die Sensorfläche leiten. Dazu kann eine entsprechende Schablone oder dergleichen in den Lichtleitmitteln selber vorhanden sein. Das weitergeleitete Licht wird auf die Sensorfläche projiziert und erzeugt die Darstellung des Symbols. Dazu ist die Sensorfläche lichtdurchlässig auszuführen.

Alternativ zu einfach ausgeführten Lichtleitmitteln in möglichst kurzer Kanalform können sie nach Art von Lichtleitern aus Kunststoff ausgebildet sein. Dadurch ist eine zentrale Anordnung mehrerer Lichtquellen für verschiedene Sensorflächen möglich. Von diesen Lichtquellen aus kann mittels der Lichtleitmittel das Licht zur entsprechenden Sensorfläche geleitet werden. Eine solche zentrale bzw. konzentrierte Anordnung von Lichtquellen kann mehrere Vorteile haben, beispielsweise bezüglich eines einfacheren Aufbaus von Schaltplatinen.

Diese und weitere Merkmale gehen außer aus den Ansprüchen auch aus der Beschreibung und den Zeichnungen hervor.

### Kurzbeschreibung der Zeichnungen

Ausführungsbeispiele der Erfindung sind in den Zeichnungen dargestellt und werden im folgenden näher erläutert. In den Zeichnungen zeigen:
- Fig. 1: einen Schnitt durch eine Berührungsschalteranordnung mit einer Sensorfläche, einer Lichtquelle und einem trichterförmigen Lichtleitmittel,
- Fig. 2: eine Ansicht der Sensorfläche von oben und
- Fig. 3: eine Darstellung des beleuchteten Symbols der Sensorfläche.

### Detaillierte Beschreibung der Ausführungsbeispiele

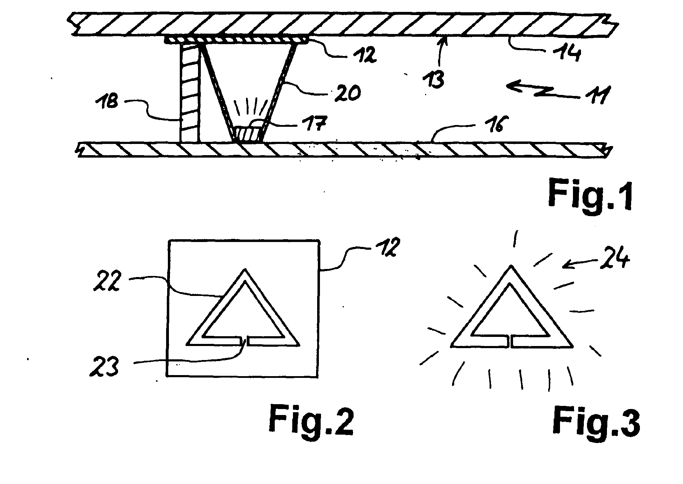

Die Berührungsschaltanordnung 11 in Fig. 1 besteht aus einer Sensorfläche 12, die an die Unterseite 13 einer Glaskeramikplatte 14 als Bedienoberfläche angelegt ist. Parallel und mit Abstand zu der Glaskeramikplatte 14 verläuft eine Leiterplatte 16, auf der sich neben weiterer elektrischer Beschaltung eine LED 17 als Lichtquelle befindet und ansteuerbar ist. Des weiteren ist eine Kontaktierung 18 in Form eines länglichen, elastischen Stifts vorgesehen, die von der Leiterplatte 16 zu der Sensorfläche 12 reicht. Diese Kontaktierung verbindet die Sensorfläche 12 elektrisch mit der Leiterplatte 16 bzw. der darauf befindlichen oder damit verbundenen Steuerschaltung für den Berührungsschalter. Gleichzeitig kann die stiftförmige Kontaktierung 18 dazu dienen, die Sensorfläche gegen die Unterseite 13 der Glaskeramikplatte 14 gedrückt zu halten, falls sie nicht auf andere Art und Weise dauerhaft befestigt ist. Vorteilhaft ist der Kontaktierstift 18 dazu elastisch, so dass mechanische Belastungen, die eine Änderung des Abstands zwischen Glaskeramikplatte und Leiterplatte 16 bewirken, ausgeglichen werden können. Die Kontaktierung 18 ist mit Vorteil auf der Leiterplatte 16 leitfähig befestigt, beispielsweise verlötet oder verklebt. Eine Kontaktierung kann auch durch ein Kabel oder dergleichen erfolgen.

Über die LED 17, die beispielsweise in SMD-Bautechnik ausgebildet ist, ist ein Lichtleitmittel in Form eines Trichters 20 gestülpt. Auf diese Weise kann gleichzeitig eine Befestigung des Trichters mittels der LED erzielt werden. Der Trichter 20 besteht vorteilhaft aus einem flexiblen Kunststoff und ist undurchsichtig bzw. lichtdicht, wobei der Kunststoff sehr dünn sein kann. Wie in Fig. 1 zu erkennen ist, reicht der Trichter 20 von der LED 17 bis vollständig an die Sensorfläche 12, so dass kein Licht an die Umgebung abgegeben wird. Auch hierzu ist es von großem Vorteil, wenn das Material des Trichters elastisch bzw. flexibel ist. Wie des weiteren aus Fig. 1 zu erkennen ist, reicht diese Art der Befestigung für den Trichter 20 aus. Durch die Einklemmung zwischen Sensorfläche 12 und Leiterplatte 16 ist er vertikal lagegesichert. Durch das Überstülpen über die LED 17 ist er horizontal lagegesichert.

Fig. 2 zeigt in Draufsicht die Sensorfläche 12. Sie weist eine im wesentlichen dreiecksförmige, schlitzartige Ausnehmung 22 auf. Diese ist geschlossen bis auf einen schmalen Verbindungssteg 23. Über diesen Verbindungssteg 23 ist auch das Innere der Ausnehmung 22 leitfähig mit der übrigen Sensorfläche 12 verbunden. Auf diese Weise beeinträchtigt die Ausnehmung 12 die Funktion der Sensorfläche für einen kapazitiven Berührungsschalter nicht bzw. nur unwesentlich.

Durch die Ausnehmung 22 kann das Licht von der LED 17 treten, so dass gemäß Fig. 3 als Symbol 24 quasi ein leuchtendes Dreieck bzw. ein dreieckiger Rahmen erzeugt wird. So stellt sich die beleuchtete Sensorfläche 12 durch eine lichtdurchlässige Glaskeramikplatte einem Benutzer dar. Des weiteren wäre es möglich, den Verbindungssteg 23 derart dünn auszuführen, dass er optisch nicht mehr wahrgenommen werden kann. Es können auch mehrere Verbindungsstege vorgesehen werden. Des weiteren ist es möglich, mittels einer durchsichtige und dennoch elektrisch leitfähige Beschichtung mit einer entsprechenden lichtundurchlässigen Maske eine Sensorfläche herzustellen, die ohne einen Verbindungssteg oder dergleichen auskommt.

Somit ist durch die Erfindung eine Möglichkeit geschaffen, bei beliebigen Arten von Sensorflächen, insbesondere bei separat an eine Bedienoberfläche anzudrückenden Sensorflächen, eine Abschirmung von zur Beleuchtung dienenden LED gegen die Umgebung bereitzustellen. Des weiteren können die Lichtleitmittel weitere Aufgaben übernehmen, beispielsweise die mechanische Lagesicherung der Sensorfläche. Auch wenn in den Figuren nur Lichtleitmittel mit im wesentlichen abschirmender Form dargestellt sind, können diese auch mit über größere Entfernungen und eventuell Winkel oder Biegungen wirkender Lichtleitfunktion versehen sein. Dies ist bei größerer Entfernung zwischen Lichtquelle und Sensorfläche erforderlich.

Somit ist es durch die Erfindung möglich, eine Berührungsschalteranordnung zu schaffen mit einer Sensorfläche. Die Sensorfläche liegt an der Unterseite einer Bedienoberfläche an. Sie ist zumindest teilweise lichtdurchlässig bzw. transparent und wird von unten mit einer LED als Lichtquelle angeleuchtet. Bei einer Ausführung der Erfindung sind trichterförmige, geschlossene Lichtleitmittel vorgesehen, die das Licht von der LED zu der Sensorfläche leiten bzw. gegen die Umgebung abschirmen. Die Lichtleitmittel können zusätzlich noch weitere Funktionen aufweisen wie Lagesicherung oder elektrische Kontaktierung der Sensorfläche.

## Patentansprüche

1. Sensorelement mit einer Sensorfläche (12), die einen Teil eines kapazitiven Berührungsschalters (11) bildet, wobei die Sensorfläche an der Unterseite einer Bedienoberfläche des Berührungsschalters angebracht ist, wobei die Sensorfläche (12) zumindest teilweise lichtdurchlässig ist und von unten mit einer Lichtquelle (17) anleuchtbar ist, wobei Lichtleitmittel (20) vorgesehen sind für den Lichtfluss von der Lichtquelle zu der Sensorfläche, wobei eine Kontaktierung in Form eines länglichen, elastischen Stifts (18) vorgesehen ist, die von einer Leiterplatte (16) zu der Sensorfläche reicht und diese elektrisch mit der Leiterplatte bzw. einer darauf befindlichen oder damit verbundenen Steuerschaltung für den Berührungsschalter elektrisch verbindet, **dadurch gekennzeichnet, dass** die an sich lose Sensorfläche (12) von den Lichtleitmitteln (20) gegen die Unterseite der Bedienoberfläche gedrückt wird, und dass die Sensorfläche ein von dem elastischen Stift (18) separates Teil ist.

2. Sensorelement nach Anspruch 1, **dadurch gekennzeichnet, dass** pro Sensorelement eine Lichtquelle (17) und/oder ein Lichtleitmittel (20) vorgesehen ist.

3. Sensorelement nach Anspruch 1 oder 2, **dadurch gekennzeichnet, dass** die Lichtleitmittel (20) die Lichtquelle (17) eines Berührungsschalters (11) gegen die Umgebung abschirmen, vorzugsweise gegen andere Berührungsschalter und/oder die übrige Unterseite (13) der Bedienoberfläche (14) abschirmen.

4. Sensorelement nach einem der vorhergehenden Ansprüche, **dadurch gekennzeichnet, dass** die Lichtleitmittel (20) eine Wandung aufweisen, die die wenigstens eine Lichtquelle (17) umgibt und ei-nen Kanal zur Sensorfläche (12) bildet, wobei vorzugsweise der Kanal im wesentlichen lichtdicht geschlossen ist.

5. Sensorelement nach einem der vorhergehenden Ansprüche, **dadurch gekennzeichnet, dass** die Lichtleitmittel (20) zumindest teilweise als Kanalwandung ausgebildet sind, wobei sie die Sensorfläche (12) gegen die Unterseite (13), der Bedienoberfläche (14) drücken, vorzugsweise elastisch gegen die Unterseite der Bedienoberfläche drücken.

6. Sensorelement nach einem der vorhergehenden Ansprüche, **dadurch gekennzeichnet, dass** die Lichtleitmittel (20) eine reflektierende Oberfläche aufweisen, vorzugsweise auf der der Lichtquelle (17) zugewandten Oberfläche.

7. Sensorelement nach einem der vorhergehenden Ansprüche, **dadurch gekennzeichnet, dass** die Lichtleitmittel (20) aus Kunststoff bestehen und/oder flexibel sind.

8. Sensorelement nach einem der vorhergehenden Ansprüche, **dadurch gekennzeichnet, dass** die Sensorfläche (12) zur Darstellung von Symbolen (24) im beleuchteten Zustand zumindest teilweise lichtdurchlässig bzw. transparent ausgebildet ist, wobei sie vorzugsweise lichtdurchlässige Ausnehmungen (22) in Form der darzustellenden Symbole (24) aufweist.

9. Sensorelement nach einem der vorhergehenden Ansprüche, **dadurch gekennzeichnet, dass** die Lichtleitmittel (20) Licht von der Lichtquelle (17) in Form eines darzustellenden Symbols (24) auf die Sensorfläche (12) leiten.

## Claims

1. Sensor element with a sensor surface (12) forming part of a capacitive touch switch (11), the sensor surface being fitted to the underside of a control surface, wherein the sensor surface (12) is at least partly light-transmitting and is illuminated from below by a light source (17), light guide means (20) being provided for the light flux from the light source to the sensor surface, contacting being provided in the form of an elongated, elastic pin (18), which extends from a printed circuit board (16) to the sensor surface and electrically connects the latter to said circuit board or to a touch switch control circuit located thereon or connected thereto, **characterized in that** the intrinsically loose sensor surface (12) is pressed by the light guide means (20) against the bottom of the control surface and that the sensor surface is a separate part from the elastic pin (18).

2. Sensor element according to claim 1, **characterized in that** there is one light source (17) and/or one light guide means (20) per sensor element.

3. Sensor element according to claim 1 or 2, **characterized in that** the light guide means (20) shield the light source (17) of a touch switch (11) against the environment, preferably against other touch switches and/or the remaining underside (13) of the control surface (14).

4. Sensor element according to one of the preceding claims, **characterized in that** the light guide means (20) have a wall, which surrounds the at least one light source (17) and forms a channel to the sensor surface (12), the channel being preferably closed in a substantially light-proof manner.

5. Sensor element according to one of the preceding claims, **characterized in that** the light guide means (20) are at least partly constructed as a channel wall and press the sensor surface (12) against the underside (13) of the control surface (14), preferably pressing elastically against the underside of the control surface.

6. Sensor element according to one of the preceding claims, **characterized in that** the light guide means (20) have a reflecting surface, preferably on the surface facing the light source (17).

7. Sensor element according to one of the preceding claims, **characterized in that** the light guide means (20) are made from plastic and/or are flexible.

8. Sensor element according to one of the preceding claims, **characterized in that** the sensor surface (12) is constructed at least partly in light-transmitting or transparent manner for displaying symbols (24) in the illuminated state and preferably has light-transmitting recesses (22) in the form of the symbols (24) to be displayed.

9. Sensor element according to one of the preceding claims, **characterized in that** the light guide means (20) guide light from the light source (17) to the sensor surface (12) in the form of a symbol (24) to be displayed.

## Revendications

1. Elément détecteur avec une surface de détecteur (12), qui fait partie d'un commutateur capacitif à effleurement (11), où la surface de détecteur est appliquée à la face inférieure d'une surface de service du commutateur à effleurement, où la surface de détecteur (12) est au moins en partie perméable à la lumière et éclairable d'en bas par une source de lumière (17), où on prévoit des moyens de conduction de lumière (20) pour le flux de lumière de la source de lumière à la surface de détecteur, où on prévoit une connexion sous forme d'un picot (18) oblong et élastique, qui s'étend d'une plaque à circuit imprimé (16) jusqu'à la surface de détecteur et qui produit un branchement électrique de celle-ci à la plaque à circuit imprimé ou encore à un circuit de commande qui se trouve sur cette plaque à circuit intégré ou qui y est raccordé, pour réaliser le commutateur à effleurement, **caractérisé en ce que** la surface de détecteur (12), libre en elle-même, est serrée par les moyens de conduction de lumière (20) contre la face inférieure de la surface de service, et **en ce que** la surface de conducteur est un élément séparé du picot (18) élastique.

2. Elément détecteur d'après la revendication 1, **caractérisé en ce que** pour chaque élément détecteur on prévoit une source de lumière (17) et/ou un moyen de conduction de lumière (20).

3. Elément détecteur d'après la revendication 1 ou 2, **caractérisé en ce que** les moyens de conduction de lumière (20) abritent la source de lumière (17) d'un commutateur à effleurement (11), de l'environnement, de préférence des autres commutateurs à effleurement et/ou du reste de la face inférieure (13) de la surface de service (14).

4. Elément détecteur d'après une des revendications précédentes, **caractérisé en ce que** les moyens de conduction de lumière (20) présentent une paroi, qui entoure au moins une source de lumière (17) et qui forme un conduit vers la surface de détecteur (12), où de préférence le conduit est fermée de manière essentiellement étanche à la lumière.

5. Elément détecteur d'après une des revendications précédentes, **caractérisé en ce que** les moyens de conduction de lumière (20) sont réalisés au moins en partie comme paroi de conduit, en serrant la surface de détecteur (12) contre la face inférieure (13) de la surface de service (14), de préférence de manière élastique.

6. Elément détecteur d'après une des revendications précédentes, **caractérisé en ce que** les moyens de conduction de lumière (20) présentent une surface réfléchissante, de préférence à la surface orientée vers la source de lumière (17).

7. Elément détecteur d'après une des revendications précédentes, **caractérisé en ce que** les moyens de conduction de lumière (20) sont constitués d'une matière plastique et/ou qu'ils sont flexibles.

8. Elément détecteur d'après une des revendications précédentes, **caractérisé en ce que** la surface de détecteur (12) est réalisée au moins en partie de manière perméable à la lumière ou encore transparente pour la représentation de symboles (24) à l'état éclairé, en présentant de préférence des évidements (22) perméables à la lumière ayants la forme des symboles (24) qui doivent être représentés.

9. Elément détecteur d'après une des revendications précédentes, **caractérisé en ce que** les moyens de conduction de lumière (20) guident la lumière de la source de lumière (17) jusqu'à la surface de détecteur (12) sous la forme d'un symbole (24), qui doit être représenté.
